# FASCICULE DE BREVET EUROPEEN

(11) **EP 1 834 924 B1**
(45) Date de publication et mention de la délivrance du brevet: **25.05.2016**
(21) Numéro de dépôt: 07104090.1
(22) Date de dépôt: 14.03.2007
(51) Int. Cl.: B81C 1/00

(54) **Encapsulation dans une cavité hermétique d'un compose microélectronique, notamment d'un MEMS**
Einkapselung in einem hermetisch abgeschlossenen Hohlraum eines mikroelektronischen Bauteiles, insbesondere eines MEMS
Packaging of a microelectronic component, in particular a MEMS, in an airtight cavity

(30) Priorité: 16.03.2006 FR 0650902
(43) Date de publication de la demande: 19.09.2007
(73) Titulaire: Commissariat à l'Énergie Atomique et aux Énergies Alternatives, 75015 Paris (FR)
(72) Inventeur: Robert, Philippe, 38100, GRENOBLE (FR)
(74) Mandataire: Ahner, Philippe

(56) Documents cités:
- EP-A2- 0 525 764
- EP-A2- 1 167 979
- WO-A2-2004/065289
- FR-A1- 2 849 014
- JP-A- 5 157 622
- US-A- 4 357 557
- US-A- 5 239 228
- US-A1- 2003 048 520
- US-A1- 2005 250 253
- US-B1- 6 635 509

## Description

### DOMAINE TECHNIQUE

L'invention se rapporte au domaine des microdispositifs, en particulier des microsystèmes électromécaniques (ou MEMS) qui sont isolés dans des cavités hermétiques.

L'invention concerne notamment un procédé de fabrication d'un tel MEMS permettant l'utilisation d'un scellement de cavités maîtrisé et peu coûteux n'altérant pas les performances des composants qui y sont localisés.

L'invention concerne également des dispositifs intermédiaires caractéristiques du procédé.

### ÉTAT DE LA TECHNIQUE ANTÉRIEURE

Les microsystèmes électromécaniques, actionneurs ou capteurs, connaissent un développement croissant. Dans de nombreux cas, le composant actif est de préférence isolé dans une cavité hermétique au gaz et à l'humidité, de manière à, par exemple, limiter son vieillissement ou augmenter la fiabilité des mesures. Il peut être souhaitable également de contrôler l'atmosphère à l'intérieur de la cavité, par exemple par un gaz neutre permettant d'éviter toute réaction chimique, ou de sceller la cavité sous un vide plus ou moins poussé. La création de ces cavités, c'est-à-dire l'encapsulation des microsystèmes (plus connue sous la terminologie anglo-saxonne de « *packaging* ») est ainsi une clef du développement des microdispositifs.

Le packaging peut être effectué à l'échelle du dispositif, avec positionnement de la puce dans un boîtier hermétique par exemple. Cette option est cependant relativement coûteuse, et limite la miniaturisation des ensembles. Une autre possibilité en expansion concerne alors l'encapsulation à l'échelle du substrat.

Il est ainsi possible de réaliser une cavité étanche autour du microsystème par des technologies de surface appropriées, option connue sous la dénomination de « packaging couche mince », par exemple décrite dans le document EP-A-0 525 764. Le problème est qu'il est difficile d'obtenir un très bon vide ou une atmosphère contrôlée dans la cavité.

Une autre option consiste à utiliser un capot reporté par scellement hermétique autour du microsystème (« *Waferlevel packaging* »). L'utilisation d'un collage de l'élément formant capot, classiquement par une colle en polymère, présentant de piètres performances en ce qui concerne l'herméticité, d'autres scellements ont été développés.

Par exemple, le scellement anodique est utilisé pour le report avec un composant en verre. Cependant, la dilatation thermique différentielle entre verre et silicium agit négativement sur les performances et écarte cette technologie pour certains MEMS.

Le scellement eutectique permet l'obtention de résultats fiables et stables. Cependant, de maîtrise délicate, cette technologie impose de fortes contraintes sur les états de surface (notamment une absence absolue d'oxydes natifs sur le silicium qui complique une utilisation à grande échelle).

Le scellement direct de silicium (ou SDB : *« Silicium Direct Bonding* ») apparaît comme l'un des plus robustes et des plus fiables. Cette technique bien maîtrisée nécessite une température de recuit élevée, et surtout d'excellents états de surface. La préparation des surfaces est idéalement effectuée par un nettoyage humide des substrats avant scellement ; cependant, dans le cas de substrats comportant des composants de type MEMS dont un élément est en suspension à faible distance d'un support, ce nettoyage par voie humide est impossible en raison du fort risque de collage des éléments par des effets de capillarité. La solution classiquement utilisée consiste alors à préparer les surfaces uniquement par des procédés secs, de type traitements plasma, qui se soldent souvent par un scellement de qualité médiocre.

Le brevet FR 2849014 divulgue un procédé de fabrication d'un dispositif microélectronique 1,2,3 comprenant une structure 1 de MEMS avec cavité 15 délimitée sur une face par un capot 5 réalisé par dépôt par gravure d'une couche 24 et sur l'autre face par une couche de matériau 2 gravée pour former un motif jusqu'à une couche 7 d'oxyde. Un évent 13 débouche dans la cavité 15

Le brevet US 6635509B1 divulgue un packaging de MEMS par dépôt d'une couche mince formant capot sur le MEMS non gravé et d'un couche mince de Ti formant un getter au dessus du MEMS avec sa cavité déjà gravée.

Le brevet US 4, 357, 557 divulgue un panneau électroluminescent dans lequel l'ensemble fonctionnel électroluminescent est encapsulé entre un panneau de verre transparent 1 et un autre panneau 11 séparés l'un de l'autre au moyen d'espaceurs 10 et collés entre eux au moyen d'un colle 12 en résine époxy. La cavité formée par l'encapsulation comprend un évent 14 et est remplie d'un liquide protecteur 13 et comprend un getter 16.

Le brevet US 5, 239, 228 divulgue également un panneau électroluminescent dans lequel une colle 52 en résine époxy avec poudre de verre fait l'adhésion entre un panneau en verre transparent 11 et un substrat 51, directement à l'interface entre ce dernier et la couche d'électrodes 12 transparentes. Un getter 55 est logé dans une gorge 53 du substrat 51 qui comprend également un évent 54.

Le brevet WO 2004/065289 concerne un dispositif microélectronique 10 avec un MEMS 16 encapsulé dans une cavité 15 dans laquelle un getter 17 est implanté; la cavité 15 étant délimitée entre un capot 11 et un substrat 13 soudés entre eux à leur périphérie 14.

### EXPOSÉ DE L'INVENTION

L'invention se propose, parmi autres avantages, de pallier les inconvénients des technologies existantes et d'utiliser la technique de scellement direct avec préparation humide des surfaces pour des composés comprenant des microsystèmes électromécaniques.

De fait, selon l'invention, le scellement direct est effectué avant libération des structures MEMS : ces dernières restent solidarisées au substrat lors du report de capot par une couche sacrificielle, notamment en SiO₂, qui est supprimée après le scellement par un traitement vapeur, par exemple à l'acide fluorhydrique, évitant les collages. La mise sous atmosphère contrôlée de la cavité se fait par la suite, par rebouchage des évents ayant servi à la libération de la structure MEMS.

Plus généralement, selon l'invention, les deux éléments constitutifs du composé microélectronique, respectivement le capot et le substrat, sont préparés chacun sur leur tranche de matériau (ou « *wafer* »), avec formations de la cavité et de la découpe de la structure MEMS jusqu'à une couche sacrificielle, de préférence un oxyde ; les surfaces avant des deux éléments, qui seront scellées l'une à l'autre, sont avantageusement en silicium, avec de préférence un substrat SOI pour le MEMS. De plus, au moins un évent débouchant dans la cavité est formé, au niveau du capot et/ou du support. Il est possible d'avoir un ou plusieurs évents par puces à packager. Ces évents peuvent être faits sur le capot ou le substrat MEMS.

Un nettoyage, de préférence humide, des surfaces destinées à être mises en contact est ensuite classiquement effectué ; les deux éléments sont mis en position pour être scellés, de préférence par scellement direct entre les deux surfaces en silicium suivi d'un recuit.

L'oxyde sacrificiel est alors gravé par un traitement de préférence gazeux, en particulier par vapeur d'HF, par l'intermédiaire des évents, qui sont enfin bouchés sous atmosphère contrôlée (vide, gaz inerte,...) par une technique appropriée. En particulier, le bouchage peut être accompli par métallisation puis fusion d'une bille métallique comme l'indium, ou fusion d'une bille en verre, ou fluage d'un phosphosilicate.

De préférence, et c'est le cas des ouvertures de contact situées du même côté que les ouvertures de libération, lors de la préparation des éléments constitutifs du composé, des cavités destinées au report de contact du MEMS sont prévues, la métallisation s'effectuant par exemple en même temps que celle du bouchage des évents. Dans le cas où une métallisation est nécessaire au bouchage (cas de l'utilisation de billes d'indium) la métallisation sert de couche d'accroche à, par exemple, la bille d'indium.

Avantageusement, une couche de matériau getter est placée dans la cavité, de préférence au niveau du capot, lors de la préparation des éléments, et recouverte d'une couche de protection, qui est supprimée après libération de la structure MEMS et avant mise sous atmosphère contrôlée.

L'invention sous un autre aspect se rapporte à un produit spécifique du procédé précédent, dans lequel un capot et un substrat sont scellés autour d'une cavité, le substrat comprenant une gravure du type usinage de structure MEMS non encore libérée, le fond de la gravure étant formé dans une couche sacrificielle, de préférence un oxyde, qui solidarise la structure MEMS à un support, une couche de matériau getter protégée étant également présente.

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatifs.
Les figures 1A à 1E illustrent les étapes d'un mode de réalisation préféré selon l'invention.
Les figures 2A et 2B montrent une alternative avantageuse dans le mode de réalisation de l'invention.

### EXPOSÉ DÉTAILLÉ DE MODES DE RÉALISATION PARTICULIERS

Les MEMS fabriqués selon l'invention peuvent être utilisés dans tous les domaines, en particulier l'automobile, l'avionique,.... Il peut par exemple s'agir de capteurs résonants sous vide, d'actuateurs radiofréquence (« *micro-switch RF* ») ou de capteurs inertiels sous atmosphère contrôlée de gaz inerte. Ces différents dispositifs sont caractérisés par le fait qu'ils comprennent au moins un élément placé en suspension au dessus d'un support, et usuellement dans une cavité hermétique. Cette « structure du MEMS » est composée d'une couche de matériau usinée selon une géométrie particulière à l'usage du MEMS qui est plus ou moins parallèle au support du composé microélectronique, à laquelle elle n'est solidarisée qu'en quelques points : on parle alors de « structure libérée ».

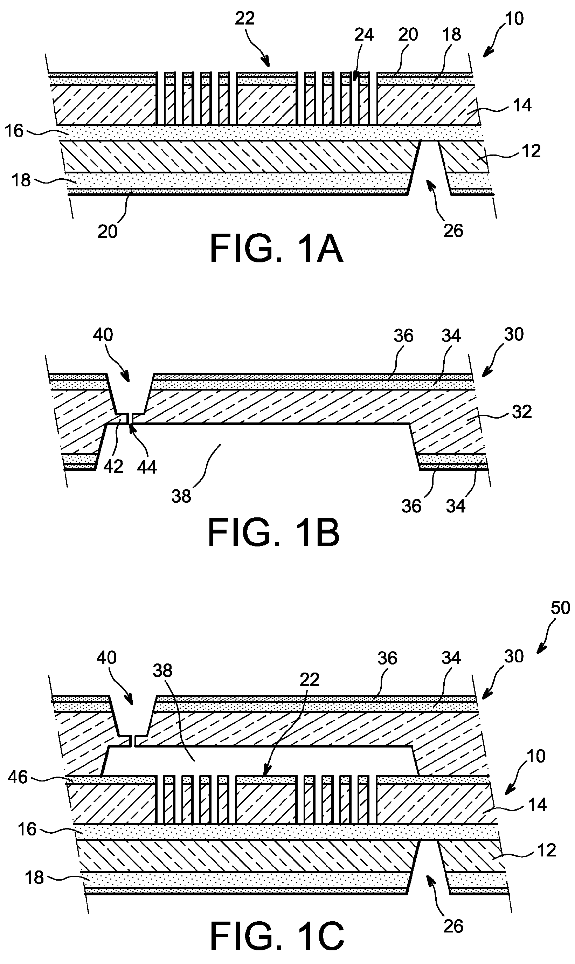

Selon un mode préféré de réalisation illustré dans la figure 1A, la structure MEMS est ainsi réalisée dans un substrat 10 qui comprend une couche support 12 et une couche supérieure 14 destinée à former l'élément en suspension, séparées par une couche sacrificielle 16. De préférence, il s'agit d'un substrat 10 SOI (« *Silicium on Insulator* ») la couche supérieure 14 en Si a une épaisseur par exemple comprise entre 2 µm et 200 µm, par exemple 60 µm, et la couche 16 d'oxyde intermédiaire a une épaisseur par exemple comprise entre 0,4 µm et 2 µm, par exemple 1 µm; il pourrait également s'agir d'autres substrats, éventuellement fabriqués spécifiquement sur une plaquette support 12 individuelle ; de préférence la couche supérieure 14 est avantageusement en silicium afin d'optimiser le scellement.

Pour les traitements futurs, il est souhaitable que les surfaces du substrat 10 soient connues de façon déterminée, par exemple soit Si ou Si surmonté d'une couche d'oxyde 18 sur chaque face (par exemple après une oxydation thermique donnant une couche de 1 µm) et une passivation surfacique 20 (par exemple un dépôt SiN de 0,3 µm).

Les différents éléments à prévoir dans le composé final sont ensuite préparés dans le substrat 10. La structure MEMS 22 sera localisée sur la face avant ou couche supérieure 14 du substrat 10, qui sera scellée avec un capot pour former une cavité. Une lithogravure de la couche supérieure 14 permet de réaliser la découpe 24 de la structure MEMS 22, qui cependant reste solidaire du support 12 par la couche intermédiaire 16. En particulier, les couches en SiN 20 et en SiO₂ 18 peuvent être gravées par plasma (procédé RIE) et la couche 14 en Si par gravure profonde (DRIE, anisotrope), avec arrêt sur la couche sacrificielle 16 en SiO₂.

Sur la face arrière (c'est-à-dire la face du substrat 10 qui restera externe, à savoir la surface libre 20 de la couche de support 12), si elles sont prévues, des reprises de contact 26 sont réalisées par une photogravure jusqu'à la couche intermédiaire 16 ; par exemple, les couches en SiN 20 et en SiO₂ 18 peuvent être gravées par RIE, et la couche 12 de support en Si peut être gravée de façon humide, par KOH ou TMAH notamment, ou par DRIE. Les gravures sont arrêtées sur la couche intermédiaire 16 sacrificielle en SiO₂.

De la même façon, le capot 30 du dispositif microélectronique est préparé, tel que schématisé en figure 1B. Avantageusement, il s'agit d'un substrat 32 en silicium, qui est poli et oxydé sur chaque face (par exemple sur une couche 34 de 1 µm) sur lesquelles est déposée une couche de passivation 36, par exemple du nitrure de silicium sur 0,3 µm. La cavité 38 d'encapsulation du MEMS 22 est obtenue par lithogravure avec masque de la face avant, en particulier par exemple une gravure RIE des couches 34, 36 SiN/SiO₂, puis une gravure humide de type KOH ou TMAH (ou éventuellement une gravure DRIE) d'une partie de la couche de substrat 32.

Selon le mode de réalisation préféré, l'autre face du capot 30 subit un traitement identique afin de graver un évent 40. La gravure de chaque face est stoppée à temps afin d'obtenir une membrane 42 de Si, par exemple d'environ 20 µm d'épaisseur, entre évent 40 et cavité 38. La membrane 42 est ouverte localement pour réaliser la connexion 44 entre évent 40 et cavité 38 soit par perçage laser (suivi éventuellement d'un nettoyage des scories par KOH ou TMAH), soit par lithogravure du silicium par l'une ou l'autre des faces (par DRIE par exemple). L'ouverture des évents pour être réalisée avant ou après scellement.

Il est possible d'avoir dans le capot 30 plusieurs évents 40 pour chaque cavité 38 ; en outre les évents, ou certains d'entre eux, peuvent être positionnés sur la tranche de substrat 10 dans laquelle est gravé le MEMS 22 et traverser le substrat 10 de part en part.

Une alternative serait par ailleurs d'utiliser un capot 30 plan et de former la cavité 38 dans la couche supérieure 14 d'un substrat, puis de graver le fond de la cavité 38 ainsi obtenue pour former la découpe 24 d'une structure MEMS 22 jusqu'à une couche sacrificielle 16 plus profonde.

Bien que décrit ici pour une cavité 38 et une structure MEMS 22, il est clair que le procédé ne s'y limite pas. En particulier, il est possible d'associer d'autres gravures pour chaque puce ainsi réalisée, et surtout de graver simultanément plusieurs cavités et structures sur une même plaquette 10, 30, afin de réaliser une tranche contenant plusieurs puces qui seront séparées une fois l'herméticité des cavités assurée.

Le capot 30 est ensuite reporté sur le support 10 puis scellé : figure 1C. A cette fin, les deux faces avant destinées à être mises en contact sont préparées, et notamment, la couche de passivation 20, 36 est gravée, par exemple par gravure humide, et la couche d'oxyde 18, 34 est supprimée. Après préparation humide sur les couches 14, 32, le scellement direct entre les deux faces nettoyées 46 est effectué, suivi d'un recuit, par exemple à 1000°C. On obtient ainsi un produit 50 comprenant une cavité 38 hermétique mais débouchant sur une face par un évent 40, ouvert ou non, et dans laquelle se trouve l'usinage 24 d'une structure MEMS 22 qui n'est pas libérée, ou seulement partiellement libérée, mais est solidarisée au support 12 par une couche sacrificielle 16.

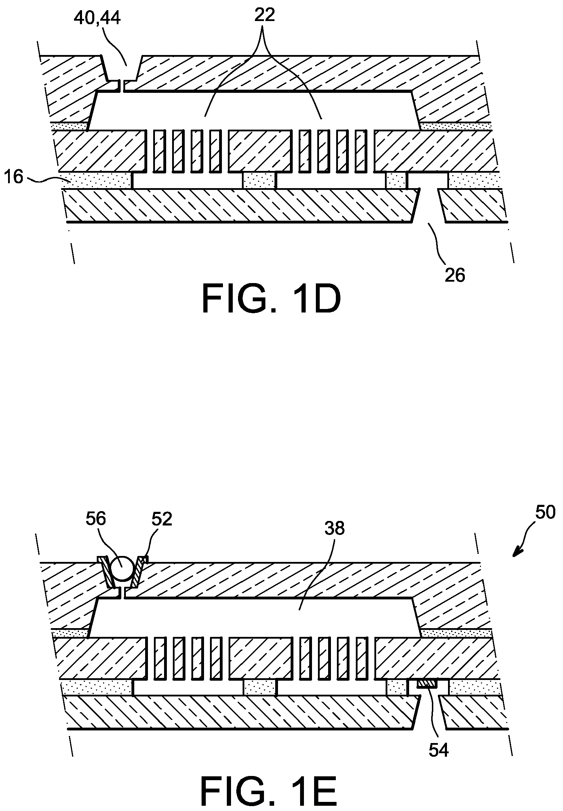

Afin de libérer la structure MEMS 22, une gravure de la couche intermédiaire 16 est effectuée, par un procédé en phase vapeur afin d'éviter un collage par capillarité entre le substrat du MEMS 14 et le support 12 : figure 1D. Par exemple, la couche 16 en SiO₂ peut être gravée par HF vapeur au travers de l'évent 40, 44. Parallèlement, la couche sacrificielle 16 est gravée au niveau des reprises de contacts 26 afin d'assurer la connexion avec la structure 22 du MEMS.

Selon une option avantageuse, il est possible de débuter la libération de la structure MEMS 22 avant scellement (entre les étapes représentées en figures 1A et 1C), sur la plaque substrat 10, après gravure DRIE : il est envisageable d'effectuer une gravure préliminaire par HF sous forme vapeur ou par gravure humide classique, ce qui permet un temps de gravure par HF vapeur après scellement plus rapide.

Le dispositif microélectronique est alors réalisé, à l'exception de la mise sous atmosphère contrôlée de la cavité 38.

Selon une option illustrée en figure 1E, la mise sous atmosphère contrôlée est réalisée conjointement à un bouchage par bille métallique fusible. Un masque mécanique permet de déposer sur l'évent 40 une métallisation 52 compatible avec le bouchage choisi, par exemple un dépôt Ti/Ni/Au (couche d'accroche). Parallèlement, la métallisation 54 des contacts 26 du MEMS 22, par exemple par Ti/Ni/Au, peut être réalisée grâce à un masque sur l'autre face. Une bille fusible 56, en particulier une bille d'indium, est mise en place dans l'évent 40, puis soumise à une fusion sous vide (ou sous atmosphère contrôlée) : la mise sous atmosphère contrôlée de la cavité 38 est accomplie en même temps que son herméticité, la bille 56 obturant totalement l'orifice 44 en fondant dans la cavité 40.

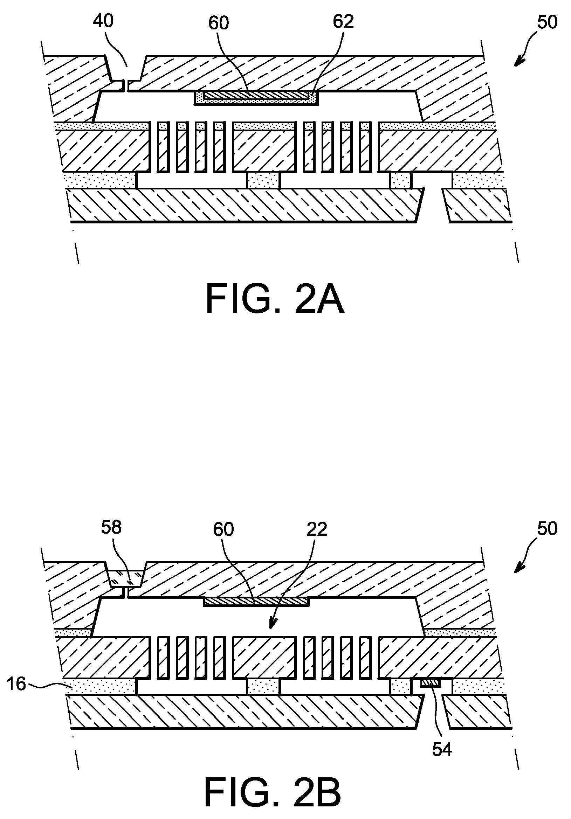

Avantageusement, le bouchage par indium pourra être remplacé par un bouchage par du verre 58, sous forme de bille ou de poudre ; dans ce cas, le trou 40 de libération ne doit pas être métallisé ; un exemple est illustré en figure 2B. Cette option présente l'avantage que le coefficient de dilatation thermique du matériau d'obturation est alors proche de celui du silicium, avantage qui peut être déterminant pour assurer une faible dépendance des capteurs à la température et améliore la fiabilité de l'herméticité.

Selon une autre option, et notamment pour des évents 40 de petite taille, notamment inférieurs à 1 µm de diamètre et dont la membrane 42 ne dépasse pas quelques microns d'épaisseur, le bouchage peut également se faire par dépôt d'une couche de type phosphosilicate (PSG), qui sera ensuite fluée par traitement thermique, sous vide ou atmosphère contrôlée.

On peut se reporter, à ce sujet, à l'Article de B. Diem et al. « Polysilicon packaging and a new anchoring technology fot thick SOI mems-dynamic response model and application to over-damped inertial sensors », Transducers 05, 13th Int; Conférence on Solid State Sensors, Actuators and Microsystems, Seoul, Korea, June 5 - 9, 2005.

Par ailleurs, grâce au procédé selon l'invention, il est possible de déposer également une couche de matériau getter 60 dans la cavité 38, afin de préserver la qualité du vide au cours du temps par ses propriétés d'absorption. Selon un mode de réalisation préféré illustré, une couche getter 60 est déposée sur la cavité 38 au moment de sa réalisation (figure 2A), puis protégée, par exemple par une couche polymère 62 résistante à la préparation au scellement SDB (c'est-à-dire notamment la gravure du nitrure de silicium et le nettoyage humide des surfaces) et à la gravure HF vapeur de libération.

Après scellement et libération de la structure MEMS 22 par de la vapeur HF (c'est-à-dire après l'étape représentée en figure 1D), et avant recuit de scellement haute température, on procède au retrait du polymère 62, soit par plasma O₂ (au travers du trou de libération 40), soit par sublimation dans le cas de l'utilisation de polymère spécifique sublimable par traitement thermique : figure 2B. Le bouchage est réalisé simultanément ou à la suite.

Grâce au procédé selon l'invention, il est ainsi possible d'obtenir :
▪ un bon rendement de fabrication du fait de l'utilisation d'un scellement SDB classique bien maîtrisé,
▪ une bonne fiabilité, grâce à l'utilisation d'un scellement SDB assurant une tenue mécanique et une herméticité de grande qualité,
▪ de bonnes performances des capteurs 22 encapsulés, notamment dans le cas de l'utilisation d'un bouchage par verre 58 à coefficient de dilatation thermique adapté à celui du silicium 12, 14, 32,
▪ une éventuelle inclusion d'un getter 60, moyennant l'utilisation d'une protection temporaire 62, ce qui accroît encore les performances d'isolement de la structure MEMS 22 au sein de la cavité 38 par rapport à l'extérieur.

Selon une variante décrite ci-dessus, on procède, sur la plaque MEMS, après gravure DRIE et avant scellement, à une pré-libération des structures par HF (vapeur ou gravure humide classique). L'intérêt est que le temps de gravure par HF vapeur avant scellement est plus rapide. Quand on fait une pré-libération ou une libération partielle (gravure telle que les zones du MEMS susceptibles de se coller sous l'effet de la capillarité restent accrochées par la couche sacrificielle sur une zone limitée), on obtient un gain de temps parce que la gravure peut être faite par voie humide. Même si elle est faite par HF vapeur, cette gravure se fait sur toute la surface du substrat et donc est plus efficace que lorsque la vapeur de HF doit passer par un évent. Le temps de prégravure est adapté en fonction des dimensions du MEMS.

## Revendications

1. Procédé de réalisation d'un dispositif microélectronique comprenant une structure de microsystème électromécanique (MEMS) dans une cavité hermétique (38) comprenant :
- la fourniture d'un substrat (10) comprenant une couche support (12), une couche intermédiaire sacrificielle (16) et une couche supérieure (14),
- la réalisation de l'usinage (24) de la structure MEMS (22) dans la couche supérieure (14) jusqu'à la couche intermédiaire (16),
- la fourniture d'un capot (30) d'encapsulation et la réalisation d'une cavité (38) dans ce capot (30),
- la réalisation d'au moins un évent (40) débouchant dans la cavité (38) dans le capot (30) ,
- le scellement du substrat (10) et du capot (30), la structure MEMS (22) se trouvant dans la cavité (38),
- la libération de la structure MEMS (22) par gravure HF vapeur de la couche sacrificielle (16) par l'intermédiaire des évents (40),
- le bouchage des évents (40).

2. Procédé de réalisation d'un dispositif microélectronique comprenant une structure de microsystème électromécanique (MEMS) dans une cavité hermétique (38) comprenant :
- la fourniture d'un substrat (10) comprenant une couche support (12), une couche intermédiaire sacrificielle (16) et une couche supérieure (14),
- la réalisation d'une cavité dans la couche supérieure (14) puis de la découpe (24) de la structure MEMS (22) dans la couche supérieure (14) jusqu'à la couche intermédiaire (16),
- la fourniture d'un capot (30),
- la réalisation dans le capot (30) et/cu le substrat (10) d'au moins un évent (40) débouchant dans la cavité (38) après le scellement du substrat (10) et du capot (30),
- le scellement du substrat (10) et du capot (3G),
- la libération de la structure MEMS (22) par gravure de la couche sacrificielle (16) par l'intermédiaire des évents (40),
- le bouchage des évents (40).

3. Procédé selon la revendication 2, dans lequel la libération de la structure MEMS (22) se fait par HF vapeur.

4. Procédé selon l'une des revendications 1 à 3 dans lequel la couche supérieure (14) du substrat (10) et le capot (30) sont en silicium, par exemple le substrat (10) est en SOI.

5. Procédé selon la revendication 4 dans lequel le scellement entre capot (30) et substrat (10) se fait par scellement direct de silicium (SDB).

6. Procédé selon la revendication 5 dans lequel, préalablement au scellement, les surfaces du capot (30) et du substrat (10) destinées à être en contact sont préparées de façon humide.

7. Procédé selon l'une des revendications 1 à 6 dans lequel le bouchage des évents (40) est associé à une mise sous atmosphère contrôlée de la cavité (38).

8. Procédé selon l'une des revendications 1 à 7 dans lequel le bouchage se fait par du verre ou par un dépôt de phosphosilicate.

9. Procédé selon l'une des revendications 1 à 7 dans lequel le bouchage est précédé du dépôt d'une couche de métal (52) et se fait par fusion d'une bille métallique (56), par exemple de l'indium.

10. Procédé selon l'une des revendications 1 à 9 comprenant en outre une étape de dépôt d'une couche getter (60) sur le capot (30) préalablement au scellement.

11. Procédé selon la revendication 10 comprenant en outre le dépôt d'une couche de protection (62) sur la couche getter (60).

12. Procédé selon la revendication 11 comprenant le retrait de la couche de protection (62) après la libération de la structure du MEMS (22).

13. Procédé selon l'une des revendications 1 à 12 comprenant en outre la réalisation de cavités destinées à des contacts (26) dans la couche support (12) avant scellement.

14. Procédé selon la revendications 13 dans lequel les cavités de contact (26) sont arrêtées au niveau de la couche intermédiaire (16) et comprenant en outre l'ouverture des contacts (26) par suppression de la couche intermédiaire (16) après scellement.

15. Procédé selon la revendication 13 ou 14 comprenant en outre la métallisation des cavités de contact (26) après libération de la structure MEMS (22).

16. Procédé selon l'une des revendications 1 à 15 comprenant en outre, avant scellement, une étape de prélibération de la structure MEMS.

17. Procédé selon la revendication 16, l'étape de prélibération étant réalisée par gravure préliminaire, par exemple de type HF sous forme vapeur ou par gravure humide.

## Patentansprüche

1. Verfahren zur Herstellung einer mikroelektronischen Vorrichtung, umfassend eine elektromechanische Mikrosystemstruktur (MEMS) in einem hermetisch dichten Hohlraum (38), umfassend:
- die Bereitstellung eines Substrats (10), umfassend eine Trägerschicht (12), eine Zwischenopferschicht (16) und eine obere Schicht (14),
- die Realisierung der Bearbeitung (24) der MEMS-Struktur (22) in der oberen Schicht (14) bis zur Zwischenschicht (16),
- die Bereitstellung eines Einkapselungsdeckels (30) und die Realisierung eines Hohlraums (38) in diesem Deckel (30),
- die Realisierung wenigstens eines Luftlochs (40), das in den Hohlraum (38) mündet, in dem Deckel (30),
- die Versiegelung des Substrats (10) und des Deckels (30), wobei sich die MEMS-Struktur (22) in dem Hohlraum (38) befindet,
- die Freilegung der MEMS-Struktur (22) durch HF-Dampfgravieren der Opferschicht (16) durch die Luftlöcher (40),
- das Verschließen der Luftlöcher (40).

2. Verfahren zur Herstellung einer mikroelektronischen Vorrichtung, umfassend eine elektromechanische Mikrosystemstruktur (MEMS) in einem hermetisch dichten Hohlraum (38), umfassend:
- die Bereitstellung eines Substrats (10), umfassend eine Trägerschicht (12), eine Zwischenopferschicht (16) und eine obere Schicht (14),
- die Realisierung eines Hohlraums in der oberen Schicht (14) und anschließend des Ausschneidens (24) der MEMS-Struktur (22) in der oberen Schicht (14) bis zur Zwischenschicht (16),
- die Bereitstellung eines Deckels (30),
- die Realisierung, in dem Deckel (30) und/oder dem Substrat (10), wenigstens eines Luftlochs (40), das in den Hohlraum (38) mündet, nach dem Versiegeln des Substrats (10) und des Deckels (30),
- das Versiegeln des Substrats (10) und des Deckels (30),
- die Freilegung der MEMS-Struktur (22) durch Gravieren der Opferschicht (16) durch die Luftlöcher (40),
- das Verschließen der Luftlöcher (40).

3. Verfahren nach Anspruch 2, bei dem das Freilegen der MEMS-Struktur (22) durch HF-Dampf erfolgt.

4. Verfahren nach einem der Ansprüche 1 bis 3, bei dem die obere Schicht (14) des Substrats (10) und der Deckel (30) aus Silizium sind, wobei das Substrat (10) beispielsweise aus SOI ist.

5. Verfahren nach Anspruch 4, bei dem das Versiegeln zwischen Deckel (30) und Substrat (10) durch direktes Silizium-Versiegeln (SDB) erfolgt.

6. Verfahren nach Anspruch 5, bei dem vor dem Versiegeln die Oberflächen des Deckels (30) und des Substrats (10), die in Kontakt sein sollen, feucht präpariert werden.

7. Verfahren nach einem der Ansprüche 1 bis 6, bei dem das Verschließen der Luftlöcher (40) einem kontrollierten Unter-Atmosphäre-Setzen des Hohlraums (38) zugeordnet ist.

8. Verfahren nach einem der Ansprüche 1 bis 7, bei dem das Verschließen durch Glas oder durch eine Abscheidung von Phosphosilikat erfolgt.

9. Verfahren nach einem der Ansprüche 1 bis 7, bei dem dem Verschließen eine Aufbringung einer Metallschicht (52) vorangeht, und es durch Schmelzen einer Metallkugel (56), beispielsweise aus Indium, erfolgt.

10. Verfahren nach einem der Ansprüche 1 bis 9, ferner umfassend einen Schritt des Aufbringens einer Getterschicht (60) auf dem Deckel (30) vor dem Versiegeln.

11. Verfahren nach Anspruch 10, ferner umfassend das Aufbringen einer Schutzschicht (62) auf der Getterschicht (60).

12. Verfahren nach Anspruch 11, umfassend das Entfernen der Schutzschicht (62) nach dem Freilegen der MEMS-Struktur (22).

13. Verfahren nach einem der Ansprüche 1 bis 12, ferner umfassend die Realisierung von Hohlräumen, die für Kontakte (26) in der Trägerschicht (12) bestimmt sind, vor dem Versiegeln.

14. Verfahren nach Anspruch 13, bei dem die Kontakthohlräume (26) auf Höhe der Zwischenschicht (16) gestoppt werden, und ferner umfassend das Öffnen der Kontakte (26) durch Beseitigung der Zwischenschicht (16) nach dem Versiegeln.

15. Verfahren nach Anspruch 13 oder 14, ferner umfassend die Metallisierung der Kontakthohlräume (26) nach dem Freilegen der MEMS-Struktur (22).

16. Verfahren nach einem der Ansprüche 1 bis 15, ferner umfassend vor dem Versiegeln einen Schritt der Vor-Freilegung der MEMS-Struktur.

17. Verfahren nach Anspruch 16, wobei der Schritt der Vor-Freilegung durch ein Vor-Gravieren realisiert wird, beispielsweise vom Typ HF in Dampfform oder durch Feuchtgravieren.

## Claims

1. Method to produce a microelectronic device comprising a micro-electro-mechanical system (MEMS) structure in a hermetic cavity (38) comprising:
- the provision of a substrate (10) comprising a base layer (12), a sacrificial intermediate layer (16) and a top layer (14),
- the machining (24) of the MEMS structure (22) in the top layer (14) up to the intermediate layer (16),
- the provision of an encapsulation cover (30) and the creation of a cavity (38) in said cover (30),
- the creation of at least one vent (40) opening into the cavity (38) in the cover (30),
- the bonding of the substrate (10) and the cover (30), the MEMS structure (22) being located in the cavity (38),
- the release of the MEMS structure (22) by means of HF vapour etching of the sacrificial layer (16) via the vents (40),
- the filling of the vents (40).

2. Method to produce a microelectronic device comprising a micro-electro-mechanical system (MEMS) structure in a hermetic cavity (38) comprising:
- the provision of a substrate (10) comprising a base layer (12), a sacrificial intermediate layer (16) and a top layer (14),
- the creation of a cavity in the top layer (14) followed by the slot (24) of the MEMS structure (22) in the top layer (14) up to the intermediate layer (16),
- the provision of a cover (30),
- the creation in the cover (30) and/or substrate (10) of at least one vent (40) opening into the cavity (38), after the bonding of the substrate ( 10 ) and the cover (30),
- the bonding of the substrate (10) and the cover (30),
- the release of the MEMS structure (22) by means of etching of the sacrificial layer (16) via the vents (40),
- the filling of the vents (40).

3. Method according to claim 2, wherein the release of the MEMS structure (22) is performed by means of HF vapour.

4. Method according to any of claims 1 to 3 wherein the top layer (14) of the substrate 10) and the cover (30) are made of silicon, for example the substrate (10) is made of SOI.

5. Method according to claim 4 wherein the bonding between the cover (30) and substrate (10) is performed by means of silicon direct bonding (SDB).

6. Method according to claim 5 wherein, prior to the bonding, the surfaces of the cover (30) and the substrate (10) intended to be in contact are prepared using a wet process.

7. Method according to any of claims 1 to 6 wherein the filling of the vents (40) is associated with placing of the cavity (38) in a controlled atmosphere.

8. Method according to any of claims 1 to 7, wherein the filling is performed using glass or phosphosilicate deposition.

9. Method according to any of claims 1 to 7 wherein the filling is preceded by the deposition of a metal layer (52) and is performed by melting a metal bead (56), for example indium.

10. Method according to any of claims 1 to 9 also comprising a deposition step of a getter layer (60) on the cover (30) before the bonding.

11. Method according to claim 10 also comprising the deposition of a protective layer (62) on the getter layer (60).

12. Method according to claim 11 comprising the removal of the protective layer (62) after the release of the MEMS structure (22).

13. Method according to any of claims 1 to 12 also comprising the creation of cavities intended for contacts (26) in the base layer (12) before bonding.

14. Method according to claim 13 wherein the contact cavities (26) are interrupted at the intermediate layer (16) and also comprising the opening of contacts (26) by removing the intermediate layer (16) after bonding.

15. Method according to claim 13 or 14 also comprising the metal coating of the contact cavities (26) after the release of the MEMS structure (22).

16. Method according to any of claims 1 to 15 also comprising, before bonding, an MEMS structure pre-release step.

17. Method according to claim 16, the pre-release step being performed by means of preliminary etching, for example HF vapour type or by means of wet etching.
